(19) **Europäisches Patentamt**

**European Patent Office**

**Office européen des brevets**

(11) **EP 0 750 400 B1**

(12) **FASCICULE DE BREVET EUROPEEN**

(45) Date de publication et mention
de la délivrance du brevet:
**25.02.2004 Bulletin 2004/09**

(51) Int Cl.⁷: **H03M 13/11**, H04L 7/04

(21) Numéro de dépôt: **96410073.9**

(22) Date de dépôt: **18.06.1996**

(54) **Circuit de calcul de syndrome**

Syndrome Rechnungsschaltung

Syndrome computing circuit

(84) Etats contractants désignés:
**DE FR GB IT**

(30) Priorité: **22.06.1995 FR 9507736**

(43) Date de publication de la demande:
**27.12.1996 Bulletin 1996/52**

(73) Titulaire: **STMicroelectronics S.A.**
**92120 Montrouge (FR)**

(72) Inventeurs:
• **Diaz Nava, Mario**
**38400 Saint Martin d'Heres (FR)**
• **Bulone, Joseph**
**38000 Grenoble (FR)**

(74) Mandataire: **de Beaumont, Michel**
**1bis, rue Champollion**
**38000 Grenoble (FR)**

(56) Documents cités:
**EP-A- 0 328 977        EP-A- 0 448 074**
**WO-A-87/06036        WO-A-87/06368**
**US-A- 5 383 203**

**Description**

La présente invention concerne un circuit de calcul de syndrome permettant, notamment, de détecter les débuts de paquets de données précédés d'en-têtes.

Sur les réseaux ATM ("Asynchronous Transfer Mode"), les données sont transmises par paquets de 53 octets, appelés cellules. Une cellule est composée d'un en-tête de 5 octets qui indique notamment la destination des données et d'une "charge" de 48 octets.

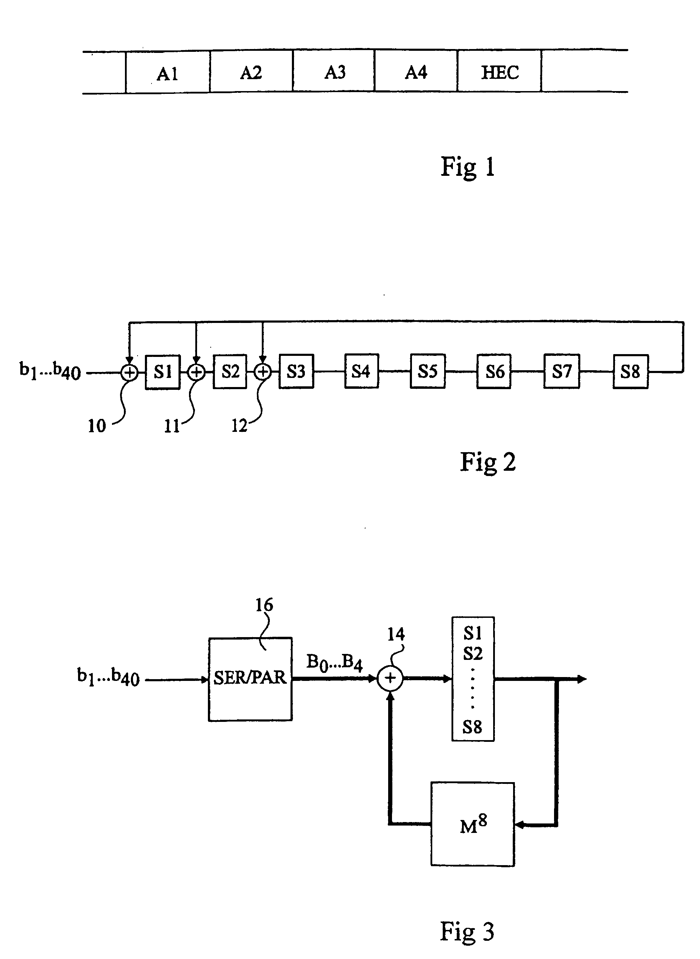

La figure 1 représente un tel en-tête. Cet en-tête comprend quatre premiers octets A1 à A4 suivis d'un octet HEC ("Header Error Control") destiné à détecter et corriger des erreurs dans les quatre premiers octets de l'en-tête. L'en-tête sert en particulier à déterminer la position des cellules dans un flot de données continu. Pour former l'octet HEC à l'émission, on commence par former le polynôme :

$$b_1 x^{31} + b_2 x^{30} + ... + b_{31} x + b_{32},$$

où $b_1$ à $b_{32}$ sont les bits des octets A1 à A4. Ce polynôme est multiplié par le polynôme $x^8$ et ensuite divisé par un polynôme dit générateur de degré 8. Le reste de cette division est un polynôme de degré 7 dont les coefficients $b_{33}$ à $b_{40}$ sont les bits de l'octet HEC.

Au niveau de la réception, les coefficients $b_1$ à $b_{40}$ constituent un polynôme de degré 39 qui est divisé par le polynôme générateur. Le reste de cette division, appelé syndrome, est nul si la transmission s'est produite sans erreur. Selon la valeur non nulle du syndrome, on détecte une erreur double ou on corrige une erreur simple.

Le document EP 0 448 074 A2 décrit un circuit de synchronisation de cellules ATM transmises par un système de communication ATM. Le circuit de synchronisation réalise une opération de CRC sur la chaîne de bits d'entrée constituant les cellules ATM reçues. Le calcul de CRC fournit des résultats Cn+1, Cn, obtenus par des décalages de 1 bit dans le calcul.

La figure 2 représente un exemple de circuit classique, dit registre à décalage à contre-réaction linéaire, ou LFSR ("Linear Feedback Shift Register"), qui sert à calculer les syndromes. Ce circuit LFSR est construit en fonction du polynôme générateur qui, dans cet exemple, est

$$x^8 + x^2 + x + 1.$$

Ce polynôme est celui utilisé généralement sur les réseaux ATM pour le calcul de l'octet HEC.

Le circuit LFSR comprend 8 bascules S1 à S8, correspondant respectivement aux coefficients S1 à S8 du syndrome, connectées en registre à décalage rebouclé. Ainsi, chaque bascule reçoit la sortie de la bascule précédente et la première bascule S1 reçoit la sortie de la dernière bascule S8. En outre, la bascule S1 est précédée d'un additionneur 10 qui reçoit la sortie de la bascule S8 et les bits successifs à analyser $b_1$ à $b_{40}$. Les bascules S2 et S3 sont précédées d'additionneurs respectifs 11 et 12 recevant chacun la sortie de la bascule précédente et la sortie de la bascule S8. Les additionneurs 10 à 12 sont en fait des portes OU exclusif.

Initialement, les bascules S1 à S8 sont à zéro. Elles sont ensuite validées à chaque arrivée d'un bit b de l'en-tête à analyser. Lorsque le quarantième bit $b_{40}$ est arrivé, les bascules S1 à S8 contiennent les coefficients du syndrome. Une fois que le syndrome a été exploité, les bascules sont remises à zéro et validées de nouveau pour calculer le syndrome d'un nouvel en-tête.

Sur les réseaux asynchrones, tels que les réseaux ATM, il faut synchroniser les circuits de réception sur les cellules de données. Pour cela, on peut se servir de la propriété de nullité du syndrome pour les en-têtes. Un circuit LFSR est alors remis à zéro après chaque paquet de 40 bits pour analyser le paquet de 40 bits suivant. Si les en-têtes sont alignés sur les paquets de 40 bits, on finit par trouver un syndrome nul lorsqu'un en-tête est analysé.

Toutefois, il est peu probable que les en-têtes soient alignés sur les paquets de 40 bits analysés. Ainsi, si un syndrome nul n'a pas été trouvé au bout d'une longueur de cellule, on doit décaler l'analyse en sautant des bits sur le flot de données (après avoir analysé le dernier paquet de la longueur de cellule, on attend un ou plusieurs bits avant de recommencer l'analyse). En procédant ainsi, on obtient un alignement des paquets analysés sur les en-têtes au bout d'au plus 40 cellules. On risque donc de perdre 40 cellules au début d'une transmission.

Pour éviter cet inconvénient, on peut prévoir 40 circuits LFSR qui analysent chacun un paquet de 40 bits décalé d'un bit par rapport au paquet analysé par le circuit précédent. Cette solution est coûteuse en surface et en consommation.

De plus, un circuit LFSR est incapable, dans les technologies courantes actuelles (CMOS), de traiter des bits arrivant aux vitesses de transmission actuellement exigées sur les réseaux ATM, c'est-à-dire des vitesses pouvant atteindre 622 mégabits par seconde.

Un objet de la présente invention est de réaliser un circuit de calcul de syndrome permettant d'effectuer une détection de début de cellule de manière particulièrement simple et évitant la perte d'un grand nombre de cellules.

Un autre objet de la présente invention est de réaliser un tel circuit dans une technologie courante tout en pouvant fonctionner aux vitesses actuelles de transmission sur les réseaux ATM.

Ces objets sont atteints en prévoyant un circuit de calcul de syndrome qui effectue un calcul glissant sur n données, les données étant des mots (des octets) et n étant le nombre de données à prendre en compte dans un calcul de syndrome (par exemple 40). Par calcul glissant, on entend qu'un nouveau syndrome est calculé à chaque arrivée d'une donnée, le syndrome étant calculé sur les n dernières données reçues. Ce calcul glissant est obtenu de façon générale en supprimant dans le circuit l'effet provoqué par la (i-n)ième donnée reçue au moment où l'on reçoit la i-ème donnée.

La vitesse de traitement est accrue lorsque les données traitées sont des mots ou des octets provenant d'une conversion série/parallèle du flot de bits. En effet, un convertisseur série/parallèle est capable de fonctionner à des vitesses particulièrement élevées, notamment celles exigées sur les réseaux ATM, et le circuit de calcul de syndrome ne doit alors fonctionner qu'à la vitesse de transmission divisée par la taille des mots.

La présente invention vise plus particulièrement un circuit de calcul de syndrome sur des paquets de n données de p bits, comprenant un registre de syndrome recevant la somme de chaque donnée reçue et du contenu du registre de syndrome modifié par une première matrice d'interconnexion correspondant à la puissance p-ième d'un polynôme générateur. Chaque donnée reçue définit un nouveau paquet de n données et la somme susmentionnée inclut la donnée précédant le nouveau paquet, modifiée par une deuxième matrice d'interconnexion correspondant à la puissance n-ième de la première matrice. Les données sont des mots dont les p bits constituent les composantes de vecteurs traités par les matrices.

Selon un mode de réalisation de la présente invention, la donnée précédant le nouveau paquet est fournie par un registre à décalage de n données, recevant les données.

Ces objets, caractéristiques et avantages ainsi que d'autres de la présente invention seront exposés en détail dans la description suivante de modes de réalisation particuliers, faite à titre non-limitatif à l'aide des figures jointes parmi lesquelles :

la figure 1 représente un en-tête de cellule transmise sur un réseau ATM ;

la figure 2 représente un circuit classique de calcul de syndrome sur un flot de bits ;

la figure 3 représente un mode de réalisation de circuit de calcul de syndrome sur un flot de mots, par exemple des octets, provenant d'une conversion série/parallèle d'un flot de bits ;

la figure 4 représente un mode de réalisation de circuit de calcul glissant de syndrome selon la présente invention, pour effectuer des calculs sur un flot de mots ;

la figure 5A illustre un mode de réalisation de circuit de calcul glissant de syndrome différent de la présente invention, effectuant des calculs sur un flot de bits ;

la figure 5B représente un exemple particulier du circuit de calcul glissant de la figure 5A ; et

la figure 6 représente un mode de réalisation selon l'invention d'un circuit de calcul glissant de syndrome sur un flot de mots, qui fournit un syndrome pour chaque bit de chaque mot.

Si l'on met en équation le fonctionnement du registre à décalage à contre-réaction linéaire de la figure 2, on obtient la relation suivante à l'arrivée du (i+1)ème bit à analyser $b_{i+1}$:

$$S(i+1) = b^*_{i+1} + M\,S(i), \tag{1}$$

où $S(i)$ est le vecteur dont les composantes sont les états S1 à S8 des bascules à l'arrivée du bit bi, $b^*_{i+1}$ est le vecteur dont la première composante est le bit $b_{i+1}$ et dont les sept composantes restantes sont nulles, et M est la matrice :

**3**

$$
M= \begin{matrix}
0 & 0 & 0 & 0 & 0 & 0 & 0 & 1 \\
1 & 0 & 0 & 0 & 0 & 0 & 0 & 1 \\
0 & 1 & 0 & 0 & 0 & 0 & 0 & 1 \\
0 & 0 & 1 & 0 & 0 & 0 & 0 & 0 \\
0 & 0 & 0 & 1 & 0 & 0 & 0 & 0 \\
0 & 0 & 0 & 0 & 1 & 0 & 0 & 0 \\
0 & 0 & 0 & 0 & 0 & 1 & 0 & 0 \\
0 & 0 & 0 & 0 & 0 & 0 & 1 & 0
\end{matrix}
$$

Cette matrice M, qui dépend du polynôme générateur utilisé, exprime les liaisons des entrées des bascules aux sorties des bascules. Chaque entrée correspond à une rangée et chaque colonne à une sortie. Si une rangée comporte plusieurs "1", cela signifie que l'entrée correspondant à la rangée reçoit la somme des sorties correspondant aux colonnes contenant les "1", cette somme étant en fait une opération OU exclusif.

En appliquant la relation (1) huit fois, c'est-à-dire jusqu'à l'arrivée du bit $b_{i+8}$, mais en exprimant le résultat en fonction de l'état S(i) des bascules, on obtient la relation :

$$
S(i+8) = B_{i/8} + M^{8} S(i), \tag{2}
$$

où $B_{i/8}$ est le vecteur de composantes $b_{i+1}$ à $b_{i+8}$, et où $M^{8}$ est la puissance huitième de la matrice M. Cette matrice $M^{8}$ s'exprime par :

$$
M^{8} = \begin{matrix}
1 & 0 & 0 & 0 & 0 & 0 & 1 & 1 \\
1 & 1 & 0 & 0 & 0 & 0 & 1 & 0 \\
1 & 1 & 1 & 0 & 0 & 0 & 1 & 0 \\
0 & 1 & 1 & 1 & 0 & 0 & 0 & 1 \\
0 & 0 & 1 & 1 & 1 & 0 & 0 & 0 \\
0 & 0 & 0 & 1 & 1 & 1 & 0 & 0 \\
0 & 0 & 0 & 0 & 1 & 1 & 1 & 0 \\
0 & 0 & 0 & 0 & 0 & 1 & 1 & 1
\end{matrix}
$$

La figure 3 représente un mode de réalisation de circuit de calcul de syndrome permettant de fonctionner sur un flot de mots, des octets dans cet exemple. Ce circuit est basé sur la relation (2) obtenue ci-dessus. Les bascules S1 à S8 constituent un registre de syndrome. Les sorties des bascules S1 à S8 sont reliées aux entrées des bascules par une matrice d'interconnexion correspondant à la matrice $M^{8}$. Pour matérialiser les liaisons selon cette matrice, on applique la règle définie pour la matrice M ci-dessus. Le registre S1-S8 est précédé d'un additionneur 14 qui effectue, en parallèle, la somme de la sortie de la matrice $M^{8}$ et de chaque octet B fourni par un convertisseur série/parallèle 16 du flot de bits b. L'additionneur 14 n'est autre qu'un ensemble de portes effectuant un OU exclusif bit à bit.

Avec cette configuration, le contenu des bascules S1 à S8 est modifié à chaque arrivée d'un octet B, c'est-à-dire à une cadence 8 fois inférieure à celle de l'arrivée des bits b. A l'arrivée du quarantième bit, le circuit traite le cinquième octet et fournit le syndrome qu'aurait fourni le circuit de la figure 2.

Comme dans le circuit de la figure 2, le registre S1-S8 de la figure 3 est remis à zéro après chaque paquet de bits pour calculer le syndrome sur le paquet de bits suivant. Ainsi, si les paquets de bits ne sont pas alignés sur les en-têtes dont on veut calculer les syndromes, il faut procéder à un alignement des paquets sur les en-têtes.

La présente invention propose une structure de circuit de calcul glissant de syndrome limitant, voire supprimant, cette phase d'alignement.

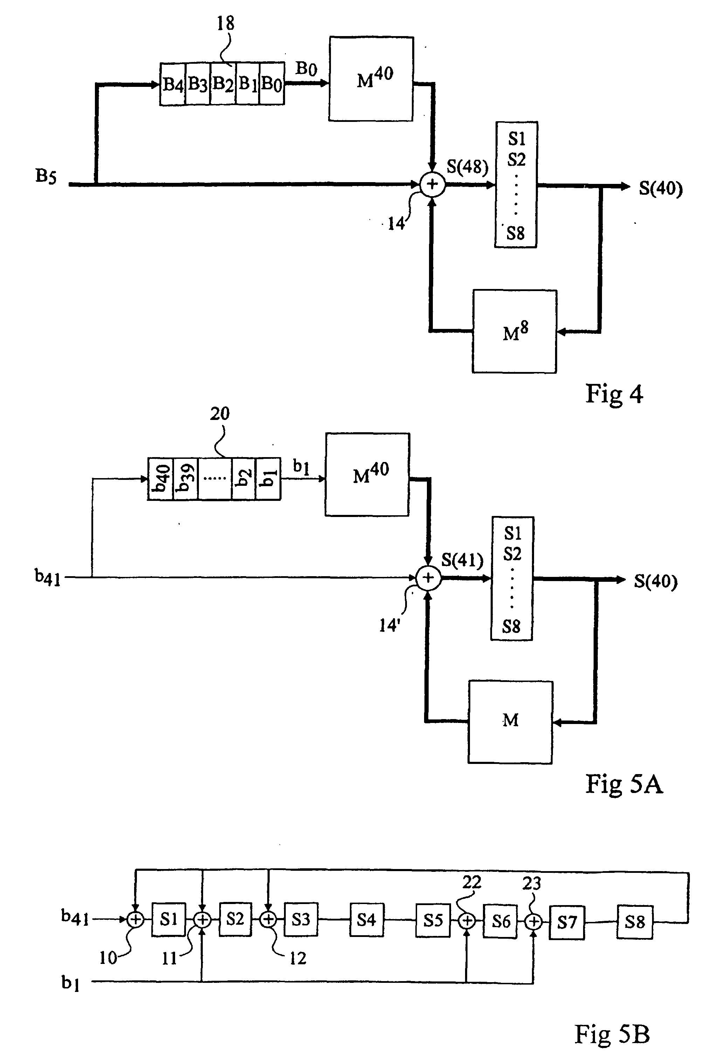

La figure 4 représente un mode de réalisation d'un tel circuit de calcul glissant de syndrome, adapté à calculer les syndromes sur des paquets de n mots, par exemple des paquets de 5 octets B. Le principe de ce circuit est d'annuler dans le registre S1-S8, à chaque arrivée d'un mot définissant un nouveau paquet, l'effet provoqué par le mot qui précède le nouveau paquet. Ainsi, de manière récursive, les effets de tous les mots qui précèdent le nouveau paquet sont annulés, ce qui a le même effet qu'une remise à zéro du registre S1-S8 au début du nouveau paquet.

Si on considère que le circuit vient de recevoir six octets $B_0$ à $B_5$, correspondant à un paquet plus un octet, et si on développe la relation (2) pour exprimer l'état S(48) du registre S1-S8 en fonction des octets $B_0$ à $B_5$, on obtient :

$$S(48) = B_5 + M^8 B_4 + M^{16} B_3 + M^{24} B_2 + M^{32} B_1 + M^{40} B_0. \tag{3}$$

Le syndrome étant à calculer sur les quarante derniers bits, ou les 5 derniers octets $B_1$ à $B_5$, le dernier terme $M^{40} B_0$ est en trop.

Pour obtenir un calcul glissant du syndrome, il suffit de supprimer le dernier terme à chaque arrivée d'un nouvel octet. Pour cela, comme cela est représenté à la figure 4, les octets B parviennent à l'additionneur 14 directement et par l'intermédiaire d'un circuit de retard 18 de 5 octets suivi d'une matrice d'interconnexion $M^{40}$. Cette matrice correspond à la puissance quarantième de la matrice M. Elle s'exprime par :

$$
M^{40} = \begin{array}{cccccccc}
0 & 0 & 1 & 1 & 0 & 0 & 0 & 1 \\
1 & 0 & 1 & 0 & 1 & 0 & 0 & 1 \\
0 & 1 & 1 & 0 & 0 & 1 & 0 & 1 \\
0 & 0 & 1 & 1 & 0 & 0 & 1 & 0 \\
0 & 0 & 0 & 1 & 1 & 0 & 0 & 1 \\
1 & 0 & 0 & 0 & 1 & 1 & 0 & 0 \\
1 & 1 & 0 & 0 & 0 & 1 & 1 & 0 \\
0 & 1 & 1 & 0 & 0 & 0 & 1 & 1
\end{array}
$$

Cette matrice définit les liaisons des entrées des bascules S1 à S8 aux bits de chaque octet fourni par le circuit de retard 18. Ces liaisons sont matérialisées selon la règle décrite en relation avec la matrice M.

Comme cela est représenté, au moment où arrive l'octet $B_5$, l'additionneur 14 fournit le futur état S(48) du registre S1-S8 alors que celui-ci est encore à l'état S(40). Le registre S1-S8 passera à l'état S(48) à l'arrivée d'un octet $B_6$.

Le circuit de retard 18 est, par exemple, une mémoire tampon (FIFO) de 5 mots de 8 bits. La mémoire 18 ne représente aucune perte de surface car elle est nécessaire pour stocker chaque en-tête lors de son traitement de détection et de correction d'erreur. La matrice d'interconnexion $M^{40}$ comporte une majorité de zéros et est donc peu complexe.

Le circuit de la figure 4 effectue un calcul glissant de syndrome octet par octet sur 5 octets. Si les octets arrivant au circuit sont alignés sur les octets des en-têtes, l'en-tête est détectée dès que son cinquième octet, HEC, est fourni au circuit. Si les octets fournis au circuit ne sont pas alignés sur ceux des en-têtes, une détection d'en-tête s'effectue au plus tard à la huitième cellule si l'on opère un saut de bit à chaque longueur de cellule. Ainsi, on peut perdre jusqu'à 8 cellules avant de détecter un en-tête, ce qui reste beaucoup plus avantageux qu'un circuit de calcul de syndrome classique, du type de la figure 2, avec lequel on peut perdre jusqu'à 40 cellules.

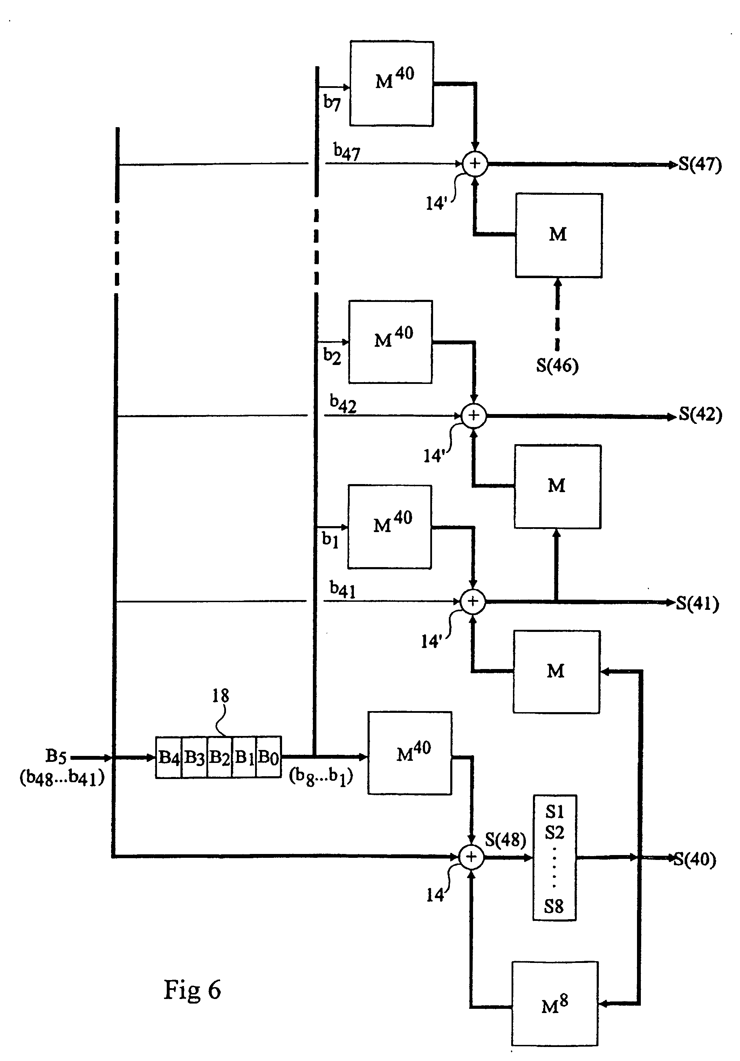

Si l'on veut éviter de perdre des cellules, on peut utiliser huit circuits du type de la figure 4 dont chacun traite des octets qui sont décalés de un bit par rapport aux octets traités par le circuit précédent. Cette solution est aussi plus avantageuse qu'une solution utilisant 40 circuits du type de la figure 2. Un mode de réalisation encore plus avantageux sera décrit ultérieurement en relation avec la figure 6.

Si la vitesse de transmission des bits est suffisamment basse, le principe susmentionné peut être appliqué sans recourir à l'invention à des bits au lieu d'être appliqué à des octets ou des mots.

La figure 5A représente un mode de réalisation d'un tel circuit permettant d'effectuer, selon l'invention, un calcul glissant de syndrome bit par bit. Les entrées des bascules S1 à S8 reçoivent les sorties de ces bascules par l'intermédiaire d'une matrice d'interconnexion M et d'un additionneur 14'. Chaque bit à traiter b est fourni directement à l'additionneur 14'. Selon l'invention, les bits b sont aussi fournis à l'additionneur 14' par l'intermédiaire d'un circuit de retard de 40 bits 20 suivi d'une matrice d'interconnexion $M^{40}$. La matrice $M^{40}$ est appliquée au seul bit de sortie du circuit de retard 20, qui est assimilé à la première composante d'un vecteur (b*) dont les sept autres composantes sont nulles.

Comme cela est représenté, au moment où arrive le bit $b_{41}$, l'additionneur 14' fournit le futur état S(41) du registre S1-S8 alors que celui-ci est encore à l'état S(40). Le registre S1-S8 passera à l'état S(41) à l'arrivée d'un bit $b_{42}$.

La figure 5B représente de manière détaillée le circuit de calcul de syndrome de la figure 5A dans le cadre de l'exemple de la figure 2. La matrice M connecte les bascules S1 à S8 entre elles comme dans la figure 2, à l'aide des mêmes portes OU exclusif 10, 11 et 12. En outre, chaque bit retardé par le circuit 20 est fourni à la porte 11 et à deux portes OU exclusif supplémentaires 22 et 23 précédant respectivement les bascules S6 et S7. En effet, si l'on applique la matrice $M^{40}$ à un vecteur de première composante $b_1$, les autres composantes étant nulles, on obtient un vecteur dont toutes les composantes sont nulles sauf la deuxième, la sixième et la septième, égales à $b_1$.

On remarquera, dans la figure 5B, que la matrice M est matérialisée par les additionneurs 11 et 12 et par la liaison de la sortie de la bascule 58 à ces additionneurs et à l'entrée de la bascule S1. La matrice $M^{40}$ est matérialisée par la seule liaison du bit retardé $b_1$ aux additionneurs 11, 22 et 23, l'additionneur 14' correspondant aux additionneurs 10, 11, 22 et 23.

La figure 6 représente un mode de réalisation de calcul glissant de syndrome octet par octet qui, pour éviter de perdre au plus huit cellules lors d'une phase d'alignement des octets reçus sur les en-têtes, fournit un syndrome pour chaque bit de chaque octet reçu.

Ce circuit comprend la structure de la figure 4 pour effectuer un calcul glissant de syndrome octet par octet, à laquelle ont été ajoutées plusieurs structures similaires à celle de la figure 5A, destinées à effectuer des calculs de syndrome bit par bit. Une structure de calcul bit par bit est prévue pour chacun des sept premiers bits des octets traités.

Chaque j-ème bit ($b_{41}$ à $b_{47}$) d'un octet reçu ($B_5$) est fourni à un additionneur 14' qui reçoit en outre le j-ème bit $b_1$ à $b_7$) fourni par le circuit de retard 18, traité par une matrice M40, et la sortie de l'additionneur 14' associé au (j-1)ième bit, traitée par une matrice M. La matrice M associée au premier bit reçoit la sortie (S(40)) du registre S1-S8.

Avec cette configuration, le registre S1-S8 et les sept additionneurs 14' fournissent 8 syndromes S(40) à S(47) calculés sur 8 paquets de 40 bits, dont chacun est décalé d'un bit par rapport au précédent. Si l'un des syndromes S(40) à S(47) est nul, l'en-tête cherchée se trouve partiellement dans le circuit 18, les bits manquants de l'en-tête étant les premiers bits du nouveau octet reçu B5. Le rang du syndrome nul indiquera le décalage à effectuer en nombre de bits pour réaliser l'alignement sur les en-têtes. Par exemple, si le syndrome S(42) est nul, le circuit de retard 18 contiendra un en-tête auquel il manque deux bits. La conversion série/parallèle effectuée en amont est alors avancée de deux bits, de manière que le prochain en-tête reçu se trouvera en totalité dans le circuit de retard 18, tandis que le syndrome contenu dans le registre S1-S8 sera nul.

La structure de la figure 6 est notablement plus simple que celle qui serait obtenue en répétant huit fois la structure de la figure 4. En effet, les matrices $M^8$ et $M^{40}$ de la figure 4, qui doivent traiter toutes les deux des vecteurs dont toutes les composantes sont variables, comportent en tout 38 portes OU exclusif, tandis que l'additionneur 14, recevant trois vecteurs dont toutes les composantes sont variables, comporte 16 portes OU Exclusif. Par contre, chacune des structures effectuant les calculs bit par bit, ne comporte que 5 portes OU Exclusif (voir figure 5B). En outre, on n'utilise qu'un seul circuit de retard 18 et un seul registre S1-S8.

Bien entendu, chacune des structures effectuant les calculs bit par bit à la figure 6 travaille à la cadence d'arrivée des octets et non à la cadence d'arrivée des bits en amont du convertisseur série/parallèle.

La présente invention est susceptible de nombreuses variantes et modifications qui apparaîtront à l'homme du métier. Notamment, l'homme du métier pourra trouver les matrices nécessaires à la réalisation du circuit selon l'invention en fonction du polynôme générateur particulier utilisé, le nombre n de bits sur lequel on calcule le syndrome, et le nombre p de bits de chaque donnée à traiter.

**Revendications**

**1.** Circuit de calcul de syndrome sur des paquets de n données de p bits, comprenant un registre de syndrome (S1-S8) recevant d'un sommateur (14) la somme de chaque donnée reçue, du contenu du registre de syndrome modifié par un circuit représentant une première matrice d'interconnexion ($M^8$) correspondant à la puissance p-ième d'un polynôme générateur, dans lequel chaque donnée reçue définit un nouveau paquet de n données, et de la donnée précédant le nouveau paquet, modifiée par un circuit représentant une deuxième matrice d'interconnexion ($M^{40}$) correspondant à la puissance n-ième de la première matrice, dans lequel les données de p bits sont des mots (B) dont les p bits (b) constituent les composantes de vecteurs traités par les matrices.

**2.** Circuit de calcul selon la revendication 1, **caractérisé en ce que** la donnée précédant le nouveau paquet est fournie par un registre à décalage de n données (18, 20), recevant les données.

**Claims**

**1.** A circuit for calculating a syndrome on packets of n p-bit data, including a syndrome register (S1-S8) receiving from an adder (14) the sum of each received datum, of the contents of the syndrome register modified by a circuit representing a first interconnection matrix ($M^8$) corresponding to the p-th power of a generator polynomial, wherein each received datum defines a new packet of n data, and of the datum preceding the new packet, modified by a circuit representing a second interconnection matrix ($M^{40}$) corresponding to the n-th power of the first matrix, wherein the p-bit data are words (B) whose p bits (b) constitute the components of vectors processed by the matrixes.

**2.** A circuit according to claim 1, **characterized in that** the datum preceding the new packet is supplied by a shift register of n data (18, 20), receiving the data.

**Patentansprüche**

**1.** Eine Schaltung zur Berechnung eines Syndroms bei Paketen von n p-Bitdaten, wobei Folgendes vorgesehen ist:

ein Syndromregister (S1-S8) zum Empfang der Summe jedes empfangenen Datums von einem Addierer (14) und zwar der Inhalte des Syndromregisters, modifiziert durch eine Schaltung, die eine erste Zwischenverbindungsmatrix ($M^8$) repräsentiert, entsprechend der p$^{\text{ten}}$ Potenz eines Generatorpolynoms, wobei jedes empfangene Datum ein neues Paket von n Daten definiert, und des Datums, welches dem neuen Paket vorausgeht und zwar modifiziert durch eine Schaltung, die eine zweite Zwischenverbindungsmatrix ($M^{40}$) repräsentiert, entsprechend der n$^{\text{ten}}$ Potenz der ersten Matrix, wobei die p-Bitdaten Worte (B) sind, deren p Bits (b) die Komponenten von durch die Matrizen verarbeiteten Vektoren bilden.

**2.** Schaltung nach Anspruch 1, **dadurch gekennzeichnet, dass** das dem neuen Paket vorhergehende Datum durch ein die Daten empfangendes Schieberegister von n Daten (18, 20) geliefert wird.

| | A1 | A2 | A3 | A4 | HEC | |
|---|----|----|----|----|-----|---|

Fig 1

$b_1 \ldots b_{40}$ —⊕— S1 —⊕— S2 —⊕— S3 — S4 — S5 — S6 — S7 — S8

10   11   12

Fig 2

$b_1 \ldots b_{40}$ → [16 SER/PAR] → $B_0 \ldots B_4$ → ⊕(14) → [S1 S2 ⋮ S8] →

$M^8$

Fig 3

Fig 4

Fig 5A

Fig 5B

Fig 6